# EUROPEAN PATENT APPLICATION

(11) **EP 3 726 394 A1**
(43) Date of publication of application: **21.10.2020**
(21) Application number: 19169878.6
(22) Date of filing: 17.04.2019
(51) Int. Cl.: G06F 15/78, G06F 17/50

(54) **RECONFIGURABLE SYSTEM-ON-CHIP**

(71) Applicant: VOLKSWAGEN AKTIENGESELLSCHAFT, 38440 Wolfsburg (DE); Goepel Electronic GmbH, 07745 Jena (DE)
(72) Inventor: AAL, Andreas, 38104 Braunschweig (DE); BUSSE, Hosea, 07743 Jena (DE)
(74) Representative: Wallinger Ricker Schlotter Tostmann

(57) **Abstract**

The invention relates to a system-on-chip, SOC, comprising: a first sub-circuit having a defined interface and a defined fixed-hardware functionality; a second reconfigurable sub-circuit being signal-connected via the interface to the first sub-circuit to exchange signals therewith; and (iii) one or more terminals for electrically connecting the SOC to its periphery. The second sub-circuit is configured as an interface circuit between the one or more terminals and the first sub-circuit. The first sub-circuit is split into a plurality of individual first circuit blocks and the second sub-circuit is split into a plurality of individual second circuit blocks. Furthermore, at least one of said first circuit block is signal-connected via one or more signal connections, each running through one or more of the second circuit blocks, to one or more other first circuit blocks or one or more of the terminals. One or more of said signal connections are reconfigurable, preferably dynamically and/or reversibly, by means of the respective one or more second circuit blocks pertaining to the respective signal connection, such that the SOC is reconfigurable before or during its operation by way of reconfiguring at least one of said second circuit blocks.

## Description

The present invention relates to the field of integrated circuits (ICs) and specifically to reconfigurable systems-on-chip (SOC). Particularly, without limitation, the invention is applicable for use in the field of automotive applications.

In many modern applications, including in particular in automotive applications, SOCs play a pivotal role in enabling such applications. For example, modern vehicle engines, e.g. car engines, air conditions, safety systems, braking systems and many other vehicle subsystems rely on and are controlled by control units incorporating one or more SOCs, such as for example microcontrollers.

Many SOCs have a fixed hardware functionally, which is defined by the respective IC design and then fixed (hard-wired) during the production process of such IC. This also applies to many SOCs that have integrated software-programmable cores, e.g. CPUs or microcontroller units (MCUs), where the reconfigurability of the SOC is strictly software-based on a fixed hardware implementation.

On the other hand, reconfigurable hardware circuits are known, such as so-called field-programmable gate arrays (FPGA), which allow for a dynamic hardware-level reconfiguration, i.e. "rewiring", of the circuit based on a respective programming of the FPGA. However, FPGAs also have significant disadvantages over ICs with a fixed hardware implementation, including in particular a lower achievable performance and a larger footprint for the same functionality and thus higher costs.

Typically, at the end of the production process of integrated circuits, in particular of SOCs, the produced IC is thoroughly tested to verify that the IC conforms to its specification. Such tests typically comprise verifying the correct electrical performance of the IC and also its environmental and mechanical performances. In some fields of application, including in the field of automotive applications, however, such ICs need to withstand varying and sometimes harsh environmental conditions, which could have an impact on the reliability of such ICs.

Currently available test and qualification procedures, including in particular the above-mentioned tests at the end of a typical production process, usually cannot adapt fast enough to the ever-changing application-specific requirements of such demanding applications, including in particular those of automotive environments. Although some currently available on-chip test solutions provide a variety of different test functionalities, these can neither be extended nor modified, esp. corrected, once the manufacturing process for such chips is completed. In particular, such known solutions do not provide the possibility to adapt or modify test functionalities in view of the occurrence of operational or environmental events while the IC is in use and is subject to changing environmental conditions and related operational loads and challenges.

As a consequence, a manufacturer of a system comprising one or more of such ICs is confronted with a scenario, where either the risks resulting from remaining test and qualification gaps need to be accepted or mitigated by additional measurements, like addition of (further) redundancy (which may cause over-engineering), or where the use of such ICs is not feasible, e.g. in the case of safety-relevant applications. The latter case is often applicable for automotive applications, which can have a negative impact on the availability or performance of features to be introduced into a vehicle that are based on the use of such ICs.

Accordingly, it is an object of the present invention to further improve the reconfigurability of integrated circuits, in particular of ICs with high performance requirements, in view of their functionality, reliability, and/or testability throughout their lifetime.

A solution to this problem is provided by the teaching of claim 1. Various preferred embodiments of the present invention are provided by the teachings of the dependent claims.

An aspect of the invention is directed to a system-on-chip, SOC, comprising: (i) a first sub-circuit having a defined interface and a defined fixed-hardware functionality; (ii) a second reconfigurable sub-circuit being signal-connected via the interface to the first sub-circuit to exchange signals therewith; and (iii) one or more terminals for electrically connecting the SOC to its periphery. The second sub-circuit is configured as an interface circuit between the one or more terminals and the first sub-circuit. The first sub-circuit is split into a plurality of individual first circuit blocks and the second sub-circuit is split into a plurality of individual second circuit blocks. Furthermore, at least one of said first circuit block is signal-connected via one or more signal connections, each running through one or more of the second circuit blocks, to one or more other first circuit blocks or one or more of the terminals. One or more of said signal connections are reconfigurable, preferably dynamically and/or reversibly, by means of the respective one or more second circuit blocks pertaining to the respective signal connection, such that the SOC is reconfigurable before or during its operation by way of reconfiguring at least one of said second circuit blocks.

The term "sub-circuit", as used herein, refers to a multi-element (e.g. multiple interconnected transistors or other electronic elements) circuit portion of the SOC, which circuit portion is present in integrated form, i.e. integrated in the SOC. Specifically and without limitation, a sub-circuit may consist of or comprise one or more semiconductor IP cores, i.e. a reusable unit of logic or functionality or a cell or a layout design that is designed as a building block to be integrated in a variety of different integrated circuits. For example, such semiconductor IP cores may be implementations of microprocessors or whole microcontroller systems, peripheral controllers or other communication-related functionality or interfaces, encoders/decoders, memory units, signal filters, or mixed-signal blocks such as A/D-converters or D/A-converters. The IP cores may even be from different vendors and may particularly be sold or otherwise distributed as soft cores or as hard cores.

The term, "fixed-hardware functionality", as used herein refers to a hardware functionality of an integrated circuit or sub-circuit thereof, which is implemented in hardware in such a way that it cannot be modified, i.e. "re-wired", through normal operation of the IC. For example and without limitation, the circuitry, i.e. hardware, of a microprocessor or microcontroller device usually has a fixed-hardware functionality (i.e. the CPU, registers, cache etc.), although, of course, the overall functionality of the microprocessor or microcontroller device, which also comprises functionality implemented in firmware of software, may be altered by replacing or modifying the firmware or software that is executed on it. To the contrary, a hardware functionality of a hardware that may be operationally restructured, e.g. "rewired", such as to change its functionality, e.g. a hardware functionality of a Field Programmable Gate Array (FPGA) or of other hardware-reconfigurable logic blocks, is not considered a "fixed-hardware functionality". Accordingly, the term "reconfigurable", as used herein, strictly refers to such a reconfigurability of a circuit on a hard-ware level, such as in the case of an FPGA, while flexibility provided solely on a software level shall not be deemed "reconfigurable".

An SOC according to the first aspect of the invention may provide numerous advantages over conventional SOC designs. In particular, it combines the advantages of fixed-hardware design blocks, particularly in the first sub-circuit, with the flexibility provided by reprogrammable circuit portions in the second sub-circuit within a single IC. While it is thus an advantage that both sub-circuits are combined within the same SOC, which thus can be handled, distributed and operated as a single device, the second sub-circuit may nevertheless each be designed as a reconfigurable circuit block that can be reused in connection with a variety of different DUTs.

The present solution thus allows for using the advantages of both predetermined fixed-hardware circuitry and flexible, i.e. reprogrammable circuitry. While the -fixed-hardware circuitry may typically be implemented at a very high level of integration and thus high performance and space efficiency (small form factor and low cost), the flexibility that may be provided specifically in the second sub-circuit forms the basis of a lot of different advanced functionalities of the overall SOC, as will be described in detail below in relation to various embodiments.

The overall structure of the SOC provides a reconfigurable interconnection structure on the one hand between the various individual fixed-hardware circuit blocks, such that their respective functionalities and features can be dynamically combined in a plurality of different ways depending on current application-specific and operational requirements of the SOC, and on the other hand between these first circuit blocks and the SOC's terminals and thus the periphery of the SOC.

Although the design layout of the first sub-circuit is split up in the plurality of individual first circuit blocks, each implementing one or more specific functionalities of the first sub-circuit, the overall functionality of the first sub-circuit, which may particularly correspond to one or more reusable semiconductor IP cores, is maintained.

A further advantage of the solution is that the configuration of the terminals of the SOC, i.e. its pinout, may remain constant over multiple versions or even generations of the SOC although these different versions or generations contain different versions of at least the first sub-circuit, the interface of which may even change from version or generation to version or generation, respectively.

In the following, preferred embodiments of the SOC are described, which can be arbitrarily combined with each other, unless such combination is explicitly excluded, e.g. when certain embodiments are only described as alternatives to each other, or technically impossible.

According to some embodiments, the fixed-hardware functionality of the first sub-circuit is an automotive-specific functionality. For example and without limitation, such functionality may relate to engine control, braking control, controlling one or more safety systems or features, air conditioning, an infotainment system, a lighting system, a head unit, communication system, body-control systems, security features (e.g. in the context of long-term upgradeability of selected systems) or a man-machine-interface of a vehicle.

According to some embodiments, the SOC is adapted to dynamically reconfigure itself during its operation by reconfiguring said at least one second circuit block based on a machine-learning based reconfiguration process. Specifically, in some related embodiments, the SOC is adapted to apply the machine-learning based reconfiguration process for dynamically determining for a current or upcoming operational scenario of the SOC a respective optimized configuration among a set of multiple possible configurations of two or more of said second circuit blocks in dependence of the values of one or more input parameters defining that operational scenario. Accordingly, in this way the interconnection structure of the SOC that is provided by the set of second circuit blocks can be automatically adapted to specific operational scenarios and thus requirements the SOC needs to meet. Those operational scenarios may particularly relate to application-specific requirements or to operational requirements of the SOC itself, e.g. thermal management, self-testing etc..

Thus, the input parameters may correspond to technical parameters characterizing these respective requirements. For example, in the case of operational requirements, the input parameters may reflect measurement results of a self-test, e.g. a temperature distribution across the SOC or current or voltage levels at particular locations within the SOC. In the case of application-specific requirements, the input parameters may for example reflect a set of different current priorities allocated to different ones of the functionalities of the first sub-circuit, or the SOC as a whole, such that the SOC can configure the interconnection structure such that circuits block having a low priority are disconnected or transitioned into a low-power mode, while circuit blocks having a higher priority remain connected. In particular, this may be performes in a way that first circuit blocks which need to collaborate in order to perform a certain application-specific become or remain interconnected through one or more intermediate second circuit blocks. Using one or more machine-learning based reconfiguration processes enables a solution, that is capable of self-adapting to a broad range of operational scenarios including operational scenarios that have not been foreseen at the time of the design of the SOC or operational scenarios which are changing over time, e.g. based on an aging process of the SOC itself or of its periphery.

According to some embodiments, a first subset of the second circuit blocks is implemented as a respective fixed-hardware circuit block and a disjoint second subset of the second circuit blocks is implemented as a respective reconfigurable circuit block, e.g. an FPGA block. In this way, the functionality of the second sub-circuit itself is based on the concept of mixing hardwired, i.e. fixed-hardware, circuit blocks, and reconfigurable circuit blocks. For example, a library of different predefined functionalities of the second sub-circuit, may be implemented by the set of hardwired second circuit blocks, each implementing one or more library elements, while the reconfigurable second circuit blocks provide an interconnection structure within the second sub-circuit itself that allows to flexibly interconnect second circuit blocks among each other and particularly to switch on or off individual library elements depending on a current operational scenario applying to the second sub-circuit.

According to some embodiments, the second sub-circuit is further configured as an integrated testing unit to test said fixed-hardware functionality of the first sub-circuit by applying one or more input signals to the first circuit and evaluating one or more output signals received via the interface from the first sub-circuit in response to the one or more input signals for conformance with one or more predetermined test criteria.

The term "integrated testing unit", as used herein, refers to a multi-element circuit portion of the SOC, which circuit portion is present in integrated form and has a testing functionality for testing the first sub-circuit or at least one or more parts thereof.

Therefore, an SOC according to these embodiments already comprises itself a testing functionality for testing the first sub-circuit, which testing may be performed during operation of the SOC during its whole lifetime. Accordingly, the first sub-circuit may be referred to as a "device under test" (DUT), which DUT is interconnected with the second sub-circuit that in turn has a testing functionality to test the DUT via its interface. In fact, this testing functionality may even be dynamically altered during the lifetime of the SOC based on its reconfigurability. As will be described in detail below, the functionality of the second sub-circuit in relation to the first sub-circuit may even comprise a variety of further aspects. In particular, the functionality of the second sub-circuit may vary over the lifetime of the SOC such as to adapt to specific developments during that lifetime and to ensure that the first sub-circuit's lifetime-determining conformance to its specification can in many cases be prolonged.

Specifically, according to some embodiments, two or more of the circuit blocks in the first subset of the second circuit blocks each implement a respective specific test instrument for testing a related aspect of said fixed-hardware functionality of the first sub-circuit. Furthermore, two or more circuit blocks in the second subset of the second circuit blocks are reconfigurable such as to selectively connect these test instruments to the first sub-circuit in order to selectively enable its testing by the respective one or more connected test instruments. This allows for a highly flexible, reconfigurable test setup for testing the first sub-circuit, wherein this test setup may be dynamically reconfigured, depending on current test needs, which in turn may specifically depend on a current or upcoming operational scenario of the SOC.

In addition, in some related embodiments, at least one of the signal connections between the first and the second sub-circuits comprises one or more dedicated measurement lines that are configured exclusively for testing, measuring or monitoring the first sub-circuit or its functionality at respective predetermined measurement points within the first sub-circuit without controlling or otherwise influencing said functionality.

According to some embodiments, the SOC is configured such that any signal between the one or more terminals and the first sub-circuit of the SOC (i.e. in forward or reverse direction or both) passes through the second sub-circuit, which thus forms a sole interface circuit between the one or more terminals and the first sub-circuit. In this way, the functionality of the second sub-circuit to be performed in relation to the first sub-circuit is not affected by any (wire-based) interaction of the first sub-circuit with another entity unknown to the second sub-circuit and therefore the second sub-circuit can take the role of gatekeeper for any signal connection between the first sub-circuit and the SOC's periphery. As will be described in more detail below, this may be particularly advantageous in view of ensuring the integrity and security of the operation of the first sub-circuit.

According to some embodiments, at least a subset of the first circuit blocks each implements a respective specific selectable predefined functional feature of a feature set of the first sub-circuit. In addition, one or more of the second circuit blocks are reconfigurable such as to selectively connect the first circuit blocks of said subset of the first circuit blocks to other second circuit blocks or one or more of the terminals in order to selectively enable the SOC to perform the respective one or more functional features of the respective connected ones of these first circuit blocks. In this way, the functionality provided by the first sub-circuit can be reconfigured, as needed by means of the second circuit blocks. Similarly, other first circuit blocks, can be disconnected at the same time.

According to some embodiments, the second sub-circuit is further configured to perform one or more of the following functions in relation to the first sub-circuit: measure or monitor one or more signals or electrical properties of the first sub-circuit and/or control or feed-back control the first sub-circuit. Such measuring and monitoring may not only be used for determining a current state or operation of the first sub-circuit, but also to measure and monitor the first sub-circuit's interaction with the second sub-circuit itself or the SOC's periphery. Controlling or feedback-controlling the first sub-circuit may particularly serve the purpose of having the second sub-circuit act as a master of the first sub-circuit acting as a corresponding slave, or of an interface circuit that transforms inputs received via the terminals from the SOC's periphery to corresponding control signals conforming to the first sub-circuits interface and capabilities to thus control the first sub-circuit accordingly based on these inputs.

According to some embodiments, the second sub-circuit is further configured - according to the following variants (i) through (iii) - to: (i) substitute one or more functionalities of the first sub-circuit by performing them in the second sub-circuit instead of the first sub-circuit; (ii) substitute one or more functionalities of a reprogrammable portion of the first sub-circuit by reprogramming that portion with program data being present in the second sub-circuit; or (iii) extend one or more functionalities of the first sub-circuit by performing one or more extensions of functionalities of the first sub-circuit.

Variant (i) may particularly be applied for replacing a no longer needed functionality of the first sub-circuit by another functionality being available in the second sub-circuit, or for defining a workaround solution in case the to-be-substitute functionality of the first sub-circuit has been found to be defect or otherwise malfunctioning. In the latter case, although the defect or malfunctioning portion itself is not corrected, a workaround is established that can take over the function of the defect/malfunctioning portion and thus ensure that the SOC as a whole continues to operate properly (i.e. conforms to specification) and that this function remains available.

On the other hand, if the first sub-circuit comprises in addition to its fixed-hardware functionality one or more reprogrammable portions and the defect/malfunctioning has its cause in one or more of these reprogrammable portions, based on variant (ii) an actual bug fix, i.e. a correction of the defect/malfunctioning portion may be achieved by reprogramming these one or more reprogrammable portions with program data being present in the second sub-circuit, e.g. as a backup solution or as part of the regular functionality of the second sub-circuit itself.

Thus, according to some embodiments related particularly to variants (i) and (ii), the functionality of the first sub-circuit to be substituted is a functionality that was detected by an error detection functionality of the SOC as being defect. Accordingly, the SOC as a whole thus may have a self-correcting capability. This is particularly useful, when the SOC is used in harsh environmental or load conditions or in applications that require a superior level of reliability, e.g. safety or security-related applications. Specifically, many automotive applications provide such tough conditions and/or have at the same time such high reliability requirements.

According to variant (iii) one or more functionalities that are implemented in the first sub-circuit may be extended by using additional resources being present in the second sub-circuit. For example, the second sub-circuit might provide additional memory capacity or processing capacity or sub-functions, such that a performance or capability of a base functionality being implemented in the first sub-circuit may be turned into an enhanced functionality based on the contribution of the second sub-circuit.

According to some embodiments related particularly to variants (i) and (ii), the second sub-circuit is further configured to substitute or extend a test functionality being implemented in the first sub-circuit itself, at least in parts. For example, if the first sub-circuit comprises test cells, such as for a boundary scan, and one or more of these test cells are detected as being defect, according to these embodiments these defect test cells may be replaced by good test cells being implemented in the second sub-circuit (cf. variant (i)). To the extent that the defect test cells are implemented in a reprogrammable portion of the first sub-circuit, also variant (ii) may be used to correct the defects.

According to some embodiments, the second sub-circuit further comprises a programmable circuit structure comprising one or more of: (i) a field-programmable gate array, FPGA, and (ii) a programmable processor platform that is configured to emulate the functionality of the second sub-circuit, at least in parts and, particularly, with respect to said testing of at least one of said fixed-hardware functions of the first sub-circuit, based on a real-time operating system running on the processor platform. These embodiments may particularly be used to implement reconfigurable or replaceable test instruments for testing the first sub-circuit or parts thereof. Specifically, the second sub-circuit may comprise a memory containing code for implementing different test instruments and depending on a current test case, an applicable code is loaded into the programmable circuit structure to be executed there for the purpose of implementing the related test instrument. In this way, a library of different test instruments may be maintained in the second sub-circuit or a separate memory circuit of the SOC or even in the first sub-circuit itself, in a very compact way, because the same programmable circuit structure can be used to dynamically implement different test instruments at different times, while the necessary code can be stored in a very space- efficient manner in a storage, e.g. nonvolatile memory (e.g. embedded flash memory) or even in a, typically highly space-efficient, read only memory (ROM).

According to some embodiments, at least one of the signal connections between the first and the second sub-circuits is an electrical connection that comprises one or more impedance matching devices being configured to optimize a proper transmission of RF-signals over this electrical connection. One advantage of combining both the first and second sub-circuits in a single SOC is particularly relevant in the case that high-frequency signals, e.g. radiofrequency (RF) signals, need to be exchanged between the two sub-circuits. Since such signals are very sensitive to all kinds of parasitic impedances and capacities and so forth, transmission of such signals over longer distances is typically challenging and requires countermeasures to maintain a sufficient signal quality. If the first and second sub-circuits are however combined close to each other within a single SOC, there are several advantages. On the one hand, the distances over which the signals need to travel from one of the sub-circuits to the other can be made very short such that adverse impacts can be limited. On the other hand, one or more suitable impedance matching devices can be provided within the signal paths, the impedance matching devices being configured such as to provide an optimized transmission of the RF signals over the respective electrical connection, i.e. signal path. This way, the reliability of the interaction between the two sub-circuits can be further enhanced, particularly in the case where the interaction is based on RF signals.

According to some embodiments, the SOC is further configured to protect data to be communicated between the first and the second sub-circuits over the signal connection by means of data encryption. This is particularly useful, if according to some embodiments discussed above, all connections between the first sub-circuit and the periphery of the SOC run through the second sub-circuit which thus plays the role of a gatekeeper. Encryption of the signal connections between the second and the first sub-circuits thus enhances the security concept based on this gatekeeper function in that it increases the difficulty of intercepting the signal path to and from the first sub-circuit and thus circumventing the second sub-circuit as a gatekeeper.

According to some embodiments, the second sub-circuit further comprises an access control functionality that is configured to monitor and control signals to be exchanged between with the SOC's periphery and the first sub-circuit based on predetermined access control rules. In this way, the gatekeeping function of the second sub-circuit may be further enhanced and the security of the operation of the first sub-circuit be further increased. Specifically, according to some related embodiments the access control functionality of the second sub-circuit may be configured to selectively grant or dismiss an access request from a requesting entity of the SOC's periphery for receiving access to the first sub-circuit as a whole or to one or more individual first circuit blocks thereof only based on a previous authentication of the requesting entity. In this way, it is also possible to implement different security levels for different types of access requests, and particularly also for different individual first circuit blocks of the first sub-circuit.

According to some embodiments, the second-sub-circuit further comprises an energy-management functionality for managing the supply of energy to the first sub-circuit or parts thereof. The energy-management functionality is configured to perform - according to the following variants (i) through (iv) - one or more of the following energy control tasks in response to receiving a respective energy control signal: (i) selectively switch on or off the respective supply of energy to one or more selected circuit portions, e.g. first circuit blocks, of the first sub-circuit; (ii) selectively cause one or more selected circuit portions of the first sub-circuit to transition into a respective low-energy mode of operation; (iii) selectively reroute at least parts of a supply of total available energy to one or more selected portions, e.g. first circuit blocks, of the first sub-circuit, such that the energy is made available only or predominantly to those selected portions, while the energy supply to non-selected portions is interrupted or reduced accordingly; (iv) selectively connect a reserve energy supply, a device or circuit configured to reduce the supply of energy, or an energy regulating circuit to a respective energy supply path of one or more selected portions, e.g. first circuit blocks, of the first sub-circuit to achieve an increase, a reduction, or a regulation, respectively, of the supply of energy to the one or more selected portions of the first sub-circuit.

Where, according to related embodiments, the SOC comprises in addition to the first and second sub-circuits one or more further sub-circuits, each having a defined interface and a defined fixed-hardware functionality, the energy-management functionality of the second sub-circuit may be further configured to perform - according to the following variants (v) through (viii) - one or more of the following energy control tasks in response to receiving a respective energy control signal: (v) selectively switch on or off the respective supply of energy to the one or more further sub-circuits; (vi) selectively cause one or more of the one or more further sub-circuits to transition into a respective low-energy mode of operation; (vii) selectively reroute at least parts of a supply of total available energy to one or more selected ones of first sub-circuit and the further sub-circuits, such that the energy is made available only or predominantly to these selected sub-circuits while the energy supply to non-selected ones of the first and the further sub-circuits is interrupted or reduced accordingly; (viii) selectively connect a reserve energy supply, a device or circuit configured to reduce the supply of energy, or an energy regulating circuit to a respective energy supply path of one or more selected ones of the first sub-circuit or the further sub-circuits or selected portions thereof to achieve an increase, a reduction or a regulation, respectively, of the supply of energy to the one or more selected ones of the first sub-circuit or the further sub-circuits or selected portions thereof.

While the predominant effect of variants (i), (ii), (v) and (vi), which may particularly be used during normal operation of the SOC, is saving energy where and when such energy consumption is currently not needed, variants (iii),(iv); (vii) and (viii) are particularly relevant in emergency situations, where the necessary energy supply for the SOC as a whole is adversely affected and a prioritization of the remaining functionality to be maintained and ensuring such functionality as long as possible are key requirements. If, for example in the case of an automotive application, the SOC is responsible for controlling the functionality of the steering wheel of the vehicle, in a scenario of a malfunctioning of the energy supply, for example if the engine goes off and the battery supply is weak or even interrupted, variants (iii) and (iv) may be used to ensure that at least the steering capability, including for example electric power steering, of the steering wheel is maintained as long as possible, while other functions, such as user interfaces for controlling entertainment, telephony or air conditioning functions may be cut off from energy supply. Specifically, rather than just switching off the energy supply of portions of the SOC that implement functionality having a respective lower priority in the given scenario, the supply paths of these energy supplies may be rerouted such that they these energy supplies can now supply energy to those portions of the SOC, which are responsible for functionality having a higher priority which needs to be maintained in the given scenario.

According to related embodiments, the SOC itself is further configured to generate the energy control signal based on a measurement of a flow of electrical energy through one or more of the terminals or over one or more electrical connections between the second sub-circuit and the first sub-circuit. Thus, the SOC itself is capable of measuring or monitoring both electrical paths outside of the SOC, to which it is connected, and electrical paths between the first and the second sub-circuits within the SOC and generate the energy control signal based on such measurements. In particular, the measurements may relate to measuring electrical current, voltage or impedance or ohmic resistance or any physical value depending from one or more of the foregoing. These measurements may particularly form the basis of an improved energy management for the whole system, to which the SOC pertains, e.g. a control unit for a vehicle, and an improved handling of detected errors and defects relating to the energy management. For example, if the measurement yields a result that indicates an unusually increased current drain at one or more of the SOCs terminals or between some of them or in one or more energy supply paths or signal paths between the second sub-circuit and the first sub-circuit, this may be interpreted as a potential malfunctioning or defect and the flow of energy through SOC may accordingly be adjusted. Such adjustment may, for example, be achieved by in that the SOC is configured to additionally connect one or more current-limiting devices, e.g. devices acting as resistors, into the respective paths, in order to limit the current and thereby prevent consequential malfunctioning or defects caused by said unusually increased current level.

Another measure to mitigate risks associated with the detected high current level may be to switch-off relevant portions of the SOC itself, e.g. selected FPGA areas or cells within the second sub-circuit, or to provide a control signal at one or more of the terminals of the SOC to cause one or more relevant portions of the overall system, to which the SOC pertains, to be switched-off or transitioned into another mode of operation, e.g. a low-power mode of operation. On the other hand, if the measurement result indicates that there is an insufficient supply of electrical energy, additional energy sources (e.g.a reserve power supply) or energy regulation means may be connected to the respective energy path in order to mitigate the risk that consequential malfunctions or defects might adversely affect the operation and reliability of the SOC or the system as a whole.

According to some embodiments, which may be implemented in the alternative or cumulatively, the energy-management functionality is further configured to: (i) receive the energy control signal in the form of an application-specific energy control signal from a host in the periphery of the SOC, when the host is executing a corresponding application program; (ii) determine, based on said energy control signal, one or more of said energy control tasks and sub-circuits or portions thereof to be impacted by such one or more tasks; and (iii) perform said determined one or more energy control tasks in relation to said determined one or more sub-circuits or portions, e.g. circuit blocks, thereof. These embodiments are particularly helpful, if it is desirable to extend the range of available different energy modes of the SOC, because in addition to a set of energy modes, which might be already available based on the hosts hardware itself, additional application-specific energy modes may be implemented on software level. Accordingly, the energy control signal may particularly indicate such an application-specific energy mode, which the application program running on the host wants the SOC to transition to, and the second sub-circuit may react accordingly and transition the SOC to that desired energy mode, which may or may not be different from an energy mode that the host hardware itself originally supports.

Where the term "comprising" is used in the present description and claims, it does not exclude other elements or steps. Where an indefinite or definite article is used when referring to a singular noun e.g. "a" or "an", "the", this includes a plural of that noun unless something else is specifically stated.

The terms first, second, third and the like in the description and in the claims, are used for distinguishing between similar elements and not necessarily for describing a sequential or chronological or spatial order. It is to be understood that the terms so used are interchangeable under appropriate circumstances and that the embodiments of the invention described herein are capable of operation in other sequences or orders than described or illustrated herein.

### BRIEF DESCRIPTION OF THE DRAWINGS

Further advantages, features and applications of the present invention are provided in the following detailed description and the appended figures, wherein:
**Fig. 1** schematically illustrates a basic functional diagram of an exemplary embodiment of an SOC according to the present invention with a first and a second sub-circuit, wherein the various sub-blocks of each of the first and second sub-circuits are not shown individually but instead the total functionality of the first and second sub-circuits is illustrated as a respective single functional block for the purposes of reducing the complexity of the illustration;
**Fig. 2** schematically illustrates an extension of the diagram of Fig. 1, wherein according to another exemplary embodiment the SOC comprises in addition a third sub-circuit;
**Figs. 3** a block diagram illustrating the structure of an exemplary SOC according to an embodiment of the present invention, where the individual circuit blocks of the first and second sub-circuits and their interconnection are shown.
**Fig. 4** a cross-sectional view of an exemplary embodiment of a system according to the present invention comprising an SOC according to any one of Figs. 1 to 3 and a further IC having a similar functionality as the SOC, but where the first and second sub-circuits are implemented in different semiconductor chips.

In the figures, identical reference signs are used for the same or mutually corresponding elements of the SOCs and systems described herein.

### DETAILED DESCRIPTION OF EMBODIMENTS

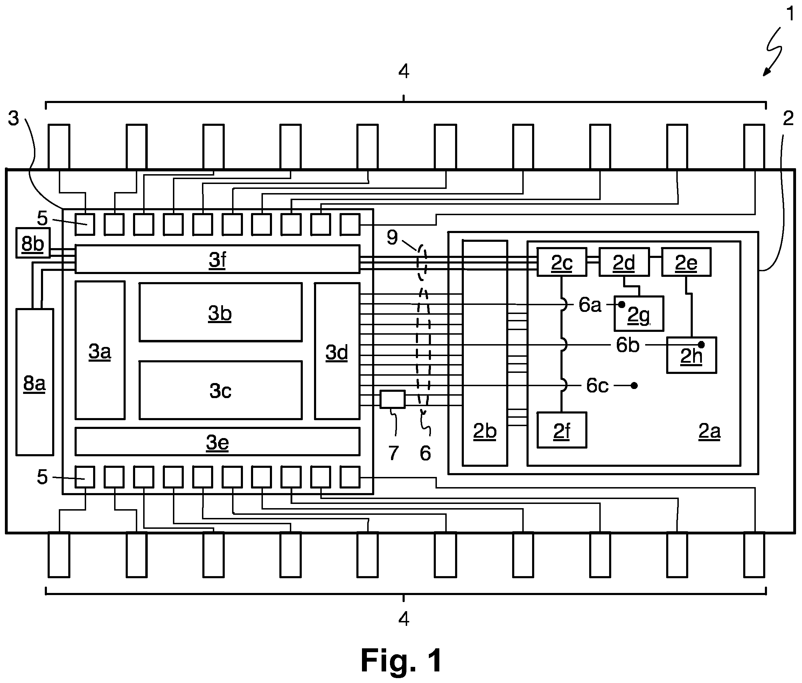

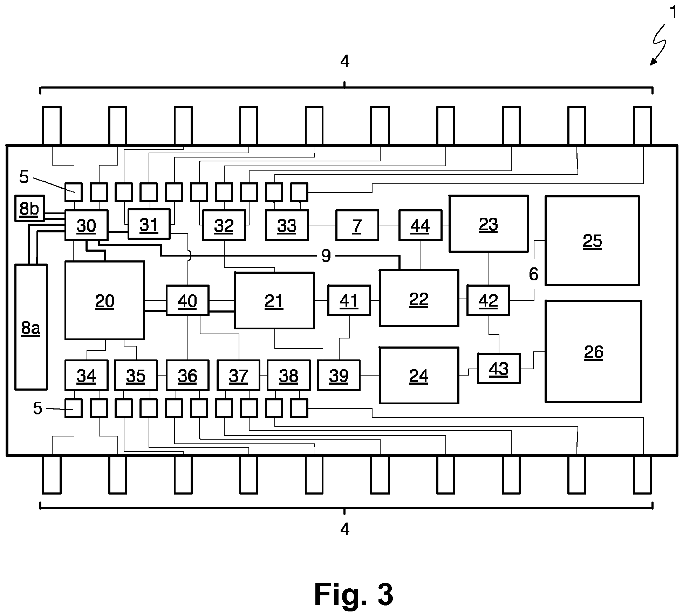

Referring to **Fig. 1**, an SOC 1 according to an embodiment of the present invention comprises a first sub-circuit 2 with a fixed-hardware functionality, for example a microcontroller, and a reconfigurable second sub-circuit 3. Each of the first sub-circuit 2 and the second sub-circuit 3 are implemented in a plurality of first or second circuit blocks 20 to 26 and 30 to 44, respectively, as shown in Fig. 3. In Fig. 1, however, the first and second sub-circuits are each drawn - solely for the purpose of reducing the complexity of the drawing - as a single circuit. Particularly, the various circuit blocks of the first sub-circuit 2 are drawn as a combined single logic design 2a. The SOC 1 has a set of terminals 4 for connecting the SOC 1 to its periphery, such as a printed circuit board of an apparatus, e.g. an electronic control unit (ECU) an automotive application, such as for example engine control, air conditioning control, and infotainment system, an electronic power steering system, or a braking system, and so forth.

Each of the terminals 4 of SOC 1 is electrically connected to respective pads 5 pertaining to the second sub-circuit 3, while there is no direct connection of the first sub-circuit 2 to any one of the terminals 4. Accordingly, the second sub-circuit 3 acts as an interface circuit and gatekeeper for the first sub-circuit 2, because the latter may only be accessed from the terminals 4 and thus the periphery of the SOC 1 through the second sub-circuit 3. Each of the first and second sub-circuits comprises a set of respective interconnected circuit blocks. However, for the sake of reducing the complexity of the illustration, those inter-block connections and internal circuitry of the various circuit blocks have not been drawn in the figures, unless for selected ones where a specific reference is made thereto in the following discussion of various embodiments.

Preferably, in view of the gatekeeper function of the second sub-circuit 3 in relation to the first sub-circuit 2, the communication over at least one, preferably all, of the signal lines 6 is protected by means of data encryption in order to prevent tampering with the SOC 1, e.g. with the objective of circumventing the gatekeeper function and getting, in spite of missing authorization, direct access to the first sub-circuit, e.g. for illegal car tuning purposes. Furthermore, the second sub-circuit 3 may comprise an access control functionality provided in a corresponding functional block 3e, in order to implement an authentication procedure, such that access to the first sub-circuit 2 from the SOC's periphery via one or more of the terminals 4 is only possible upon successful authentication.

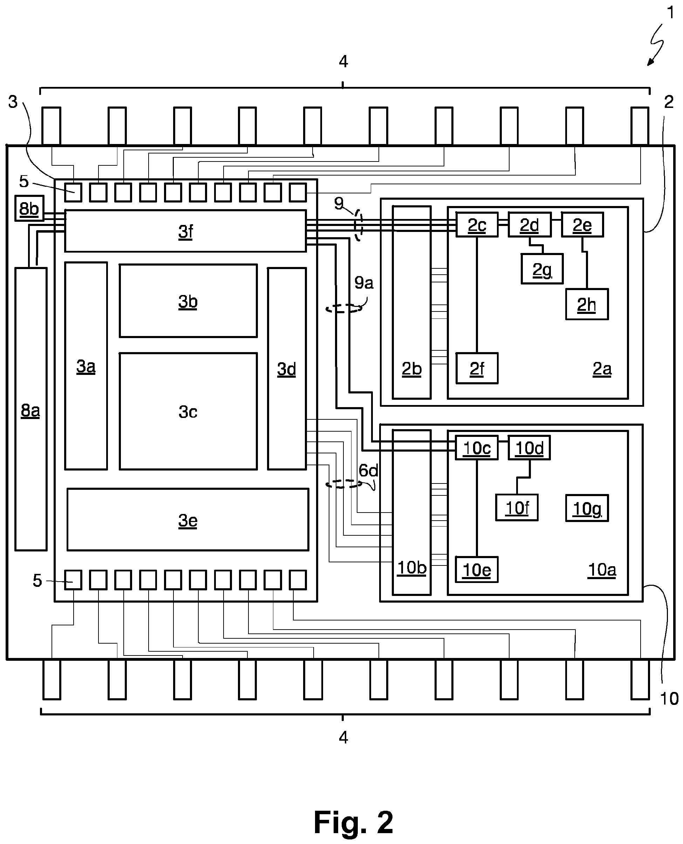

In this non-limiting exemplary embodiment, the second sub-circuit 3 is particularly designed as a testing unit for testing the hardware functionality, in particular the logic design 2a respectively the individual (second) circuit blocks of the first sub-circuit 2 (which may thus be referred to as a device or design under test, DUT) by applying by an interface block 3d of the second sub-circuit 3 one or more input signals over a set of signal lines 6 to an interface 2b of the first sub-circuit 2 and evaluating one or more output signals received in return via the interface 2b from the first sub-circuit 2 in response to the one or more input signals for conformance with one or more predetermined test criteria. Interface 2b may be as simple as comprising only electrical contact points for connecting the second sub-circuit 3 to the first sub-circuit 2, or it may have higher complexity and also comprise one or more interface functionalities, e.g. I/O functionality like voltage limiters, charge pumps, signal filters etc. It is noted, that each of the blocks shown in Fig. 2 may itself comprise a plurality of individual circuit blocks. Specifically, interface block 3d comprises in fact a plurality of individual interface portions being distributed across the various individual (first) circuit blocks of the second sub-circuit.

Such test criteria may include, for example, whether (i) a measured potential is below or above a predefined voltage threshold, (ii) a measured current is below or above a predefined current threshold, (iii) a local temperature is below or above a predefined temperature threshold, or (iv) a signal frequency is below or above a predefined signal threshold. Specifically, signal lines 6 that are designed to carry high frequency signals, such as radiofrequency (RF) signals, may comprise specific impedance matching devices 7 in order to optimize the transmission of such high-frequency signals over the respective signal lines without unacceptable dampening or other adverse frequency-dependent effects. Other possible test criteria may relate to other measurable properties and operational states of the first sub-circuit 2.

In addition to regular signal lines 6 running between the interface block 3d of the second sub-circuit and the interface 2b of the first sub-circuit, specific dedicated measurement lines 6a, 6b and 6c may run between the interface block 3d and selected measurement locations within the logic design 2a of the first sub-circuit 2. This allows for in situ measurements at those selected locations without affecting the functionality of the first sub-circuit 2. The selected locations may particularly relate to portions of the first sub-circuit 2 that are subject to superior stress, e.g. because of above-average currents, voltages, temperatures or frequencies.

While the measurement may be a one-time measurement, which may for example be performed only upon booting the SOC, it may alternatively take place on a regular basis, for example in fixed time intervals or in specific predetermined situations. Furthermore, a substantially continuous monitoring is possible, which may be particularly useful for safety relevant applications.

The functionality, including in particular the test functionality, of the second sub-circuit 3 is based on a set of functional blocks of the second sub-circuit 3, including a reprogrammable block, for example in the form of a field programmable gate array (FPGA), a controller block 3b, a memory block 3c, e.g. in the form of embedded flash memory, the interface block 3d and access control block 3e. In addition, the second sub-circuit 3 may comprise other blocks (not drawn) as well. As already noted, each of those blocks may itself comprise a plurality of individual separately arranged circuit blocks.

Specifically, the controller block 3b may have a number of different functions, including, on the one hand, controlling the measurements in relation to the first sub-circuit 2, as discussed above. On the other hand, the controller block 3b is configured to evaluate the obtained measurement results and react accordingly in order to maintain the desired functionality of the first sub-circuit 2 and thus the SOC 1 as a whole. To that purpose, the second sub-circuit 3 may be adapted to control or feedback-control the first sub-circuit 2 or parts thereof, such as specific circuit blocks relating to specific functionalities of the first sub-circuit 2. For example, the controller block 3b may control signals being exchanged over signal lines 6 between the second and the first sub-circuits and change them or switch them on and off in dependence from the measurement results obtained.

Furthermore, if the measurement results indicate a defect in the first sub-circuit 2 in relation to a particular functionality thereof, the controller block 3b may initiate a substitution of that defect functionality of the first sub-circuit 2 by a corresponding functionality of the second sub-circuit, which may particularly be implemented in the reprogrammable (FPGA) block 3a of the second sub-circuit 3. To that purpose, the controller block 3b may load a corresponding program pattern from the memory block 3c where it had been previously stored as an element of a library containing a set of different program patterns for different purposes.

Alternatively, controller block 3b may communicate a respective program pattern for fixing the defect to a dedicated reprogrammable functional block 2h of the first sub-circuit 2 itself, if such block 2h is present and the defect can be allocated to that reprogrammable block 2h. Specifically, that reprogrammable block 2h may itself define a test functionality, e.g. a boundary scan functionality, of the first sub-circuit 2 itself. Accordingly, if the test functionality has been found to be malfunctioning or otherwise defective, it can be fixed by reprogramming block 2 based on a program pattern provided by the second sub-circuit 2 in response to detecting the malfunctioning or defect error detection functionality of the SOC 1, which might be implemented in any one of the first and second sub-circuits 2 or 3, respectively, or even elsewhere within the SOC 1.

Furthermore, in addition to its test functionality, the second sub-circuit 3 comprises an energy management block 3f for managing the energy supply of the first sub-circuit 2. Specifically, the first sub-circuit 2 comprises within its logic design 2a exemplary first, second and third functional blocks 2f, 2g and 2h in the form of circuit blocks. Each of these circuit blocks has a corresponding energy supply block 2c, 2d and 2c, respectively, which may particularly be any integrated current or voltage sources, such as for example voltage regulators or charge pumps or simply a switching circuit or device, e.g. a transistor, capable of selectively connecting or disconnecting the respective functional block with a power input or other energy supply of the logic design 2a or of the first sub-circuit 2 as a whole.

The first sub-circuit 2 may particularly receive its power supply from the second sub-circuit 3 over respective power supply lines 9 running between the two sub-circuits. As shown in Fig. 1, these power supply lines 9 may be connected to said energy supply blocks 2c, 2d and 2e, which in turn can switch on or off, regulate or boost or reduce the power supply of the corresponding functional blocks 2f, 2g and 2h of the first sub-circuit 2 in response to respective control signals received from the energy management block 3f of the second sub-circuit 3. Specifically, in order to reduce the necessary power supply for those functional blocks, one or more of them may be selectively transitioned into a low-power mode of operation, such as a sleep mode, if their functionalities are currently not needed or, in a scenario of insufficient overall power supply, have lower priority than other functionalities that need to maintained in the course of an emergency mode.

The second sub-circuit 3, in turn, may receive its power from a primary energy supply 8a within the SOC. Primary energy supply 8a may correspond to one or more power input terminals 4 of the SOC 1 or to an energy supply unit within the SOC 1, such as a voltage regulator or charge pump or other circuit for supplying electrical energy. In addition, SOC 1 may comprise a reserve energy supply 8b which is not used during normal operation of the SOC 1 but is instead used as a backup energy supply for supporting an emergency functionality of the SOC 1, if the primary energy 8a supply breaks away or becomes otherwise unreliable or insufficient.

Accordingly, in such a situation, the energy management block 3f may have a functionality to selectively direct energy from the reserve energy supply 8b only to those high prioritized functional blocks of the SOC 1, including in particular respective high prioritized circuit blocks of the first sub-circuit 2. In addition, energy management block 3f may selectively reroute at least parts of the energy being supplied by the primary energy supply 8a or the reserve energy supply 8b, as the case may be, in order to ensure, that the energy is solely, or at least primarily provided to those functional blocks within SOC 1, which have the highest priority in a given scenario.

For example, if in the case of an automotive application, e.g. engine control, the primary energy supply 8a fails, energy management block 3f may selectively connect reserve energy supply 8b to selected functional blocks of SOC 1 and particularly first sub-circuit 2 that are necessary to maintain an emergency functionality of the engine, which is for example sufficient to pull the vehicle to the side of the road before the engine goes off. In addition, if the primary energy supply 8a has not fully ceased to provide energy, energy management block 3f may reroute the flow of energy from the primary energy supply 8a by disconnecting lower prioritized functional blocks from the energy supply and directing the flow of energy instead to the higher prioritized functional blocks needed in said emergency scenario. Accordingly, those higher prioritize functional blocks may not only receive their regular energy supply, but they may even be supplied with additional energy in order to safeguard their functionality in a given scenario.

The rerouting may also be used in other, non-emergency scenarios, if at least temporarily an extra amount of energy is necessary. This may for example be the case, if SOC 1 comprises a flash memory and a flashing (erasing) operation needs to be performed which temporarily consumes above-average energy above a level that the standard energy supply of that flash memory can provide.

**Fig. 2** shows another embodiment of an SOC 1 according to the present invention. This embodiment is based on the embodiment of Fig. 1 and contains all of its features. It differs, however, from the embodiment of Fig. 1, in that the SOC 1 comprises a further sub-circuit 10, hereinafter referred to as a third sub-circuit, which as yet another functionality to the SOC 1 and is a further DUT comprised therein. Accordingly, the second sub-circuit 3 is adapted to not only perform its control, test, energy management, access control and other functions, as described above with reference to Fig 1, in relation to the first sub-circuit 2 (DUT1), but also for the third sub-circuit 10 (DUT2) and in a similar manner. Of course, the number of DUTs is not limited to two and accordingly further sub-circuits (DUTs) may be present as well. The third sub-circuit 10, as well as any potentially present additional sub-circuits, may be implemented as a single compact design block, or similarly to the first sub-circuit, as a set of individual design (circuit) blocks which can be arranged separately within the design and layout of the SOC 1.

The third sub-circuit 10 comprises, in a similar manner as the first sub-circuit 2, a functional logic design 10a including various sub-blocks, such as by way of example sub-blocks 10e, 10f, 10g, and an interface 10b for interfacing with the second sub-circuit 3 over signal lines 6a and power lines 9a (the signal lines 6 of the first sub-circuit 2 have not been drawn in Fig. 2). The logic design 10a further comprises energy supplies 10c and 10d, which are controllable, in a similar manner as energy supply blocks 2c, 2d and 2e of the first sub-circuit 2, by control signals received from the second sub-circuit 3 over one or more of signal lines 6a and the interface 10b. Sub-block 10g, however, is an example of a sub-block that does not have an individual controllable energy supply under the control of the second sub-circuit. For example, sub-block 10g may relate to a principal key functionality of the logic design 10a which has to be powered in any case for maintaining the usability of the third sub-circuit 10 or even the SOC 1 as a whole and thus has no need of being selectively deactivated or put into a low power mode.

Referring to **Fig. 3**, the structure of an exemplary SOC 1 according to an embodiment of the present invention comprises a semiconductor substrate having integrated thereon a first sub-circuit 2, which is distributed across a set of exemplary individual first circuit blocks 20 to 26, and a second sub-circuit 3, which is distributed across a set of exemplary individual second circuit blocks 30 to 44. The first circuit blocks 20 to 44 are distributed across the layout of the SOC 1 and interconnected in such a way that each first circuit block is signal-connected via one or more signal connections 6 (only one of which is marked with the reference sign 6), each running through one or more of the second circuit blocks 30 to 44, to one or more other first circuit blocks 20 to 26 or one or more terminals 4 of the SOC 1. Moreover, one or more of said signal connections 6 are reconfigurable, preferably dynamically and reversibly, by means of the respective one or more second circuit blocks 30 to 44 pertaining to the respective signal connection 6, such that the SOC 1 is reconfigurable during its operation by way of reconfiguring at least one of said second circuit blocks 30 to 44.

Accordingly, in this exemplary embodiment, there is no direct connection between any one of the first circuit blocks 20 to 26 and a pad 5 respectively a terminal 4 connected thereto, and thus the periphery of the SOC 1. Any connection between one of the first circuit blocks 20 to 26 and a terminal 4 of SOC 1 runs through at least one of the second circuit blocks 30 to 44, which thus collectively provided gatekeeper function for the first sub-circuit 2. It is noted, however, that in other embodiments, there may be in addition one or more direct connections between a first circuit block and one or more other first circuit blocks and/or one or more of the terminals.

While all of the circuit blocks or connectable (most connections not drawn) directly or indirectly to a primary power supply 8a of the SOC 1, at least a subset comprising one or more of the second circuit blocks, in the present example circuit blocks 30 and 31, comprises an energy management function for at least a subset of the first circuit blocks, in the present example circuit blocks 20 to 22, as discussed in detail above. To that purpose, the circuit blocks 30, 31 are connected, directly or indirectly to the primary power supply 8a on the one hand, and are designed to selectively connect each of blocks 20 to 22 via respective power lines 9 to at least one of the primary power supply 8a and an additional reserve power supply 8b, or disconnect them therefrom. Each of power supplies 8a and 8b may be on-chip, e.g. in the form of a voltage regulator or charge pump or any other kind of voltage source or current source or alternatively off-chip and connectable through a subset of terminal 4 to respective power lines on SOC 1.

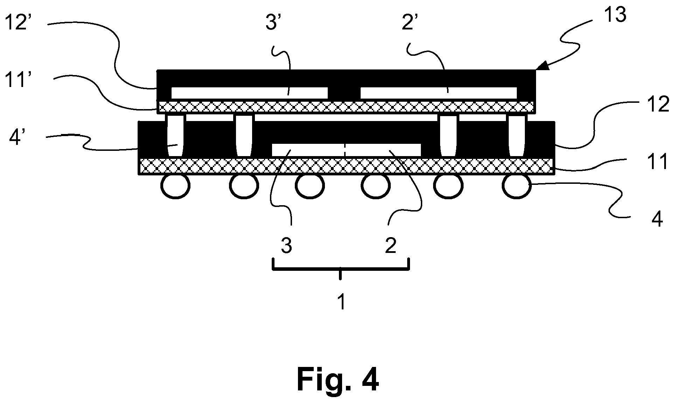

Referring to **Fig. 4**, an SOCs 1 according to embodiments of the present invention may particularly be combined within a same system with one more other SOCs 1, or with an electronic component 13 or a set of individual electronic components that also comprises a respective first sub-circuit 2' and a respective second sub-circuit 3', each having the respective functionality described herein for sub-circuits 2 and 3, respectively, Particularly, the SOC 1 and one or more of said electronic components 13 may be combined to form together, optionally with further sub-circuits or SOCs, a SIP, an MCM, a system comprising a common substrate (e.g. PCB) on which SOCs 1 and this at least one further electronic component is mounted. In the latter case at least one of the SOC 1 and the electronic components 13 may be embedded, at least partially, in a recess of the common substrate, or (as presented in Fig. 4) stacked atop each other in a package-on-package (PoP) structure. Therein, SOC 1 comprises a package substrate 11 having terminals 4 and a mold mass 12 for encapsulating the SOC 1. The electronic component 13 comprises its own package substrate 11' having terminals 4', a first sub-circuit 2' and a second sub-circuit 3', together encapsulated by a mold mass 12'.

Such a system may have the advantage that the respective strengths of both types of embodiments, multi-chip and SOC, can be used at the same time in a suitable partitioning. Particularly, components of the system, for which it is preferable that the respective second sub-circuit is integrated on the same semiconductor die as the first sub-circuit, for example if RF signals need to be exchanged between the two sub-circuits, can be preferably provided as an SOC embodiment. Other components of the system, however, and particularly those where the manufacturing technology for the second sub-circuit needs to be substantially different from the manufacturing technology for the first sub-circuit or where frequent product updates are expected and necessary, might preferably be provided as a multichip embodiment. For example, if the second sub-circuit is not limited to a logic design but further comprises power circuitry or significant memory circuitry, its manufacturing technology might have to be significantly different from that of the first sub-circuit that may for example only require standard CMOS technology, and thus an implementation according to the multichip embodiments will be necessary or at least preferable.

While above at least one exemplary embodiment of the present invention has been described, it has to be noted that a great number of variation thereto exists. Furthermore, it is appreciated that the described exemplary embodiments only illustrate non-limiting examples of how the present invention can be implemented and that it is not intended to limit the scope, the application or the configuration of the herein-described apparatus' and methods. Rather, the preceding description will provide the person skilled in the art with constructions for implementing at least one exemplary embodiment of the invention, wherein it has to be understood that various changes of functionality and the arrangement of the elements of the exemplary embodiment can be made, without deviating from the subject-matter defined by the appended claims and their legal equivalents.

### LIST OF REFERENCE SIGNS

- 1: SOC
- 2: first sub-circuit
- 2a: functional logic design block, e.g. microcontroller, of first sub-circuit,
- 2b: interface of first sub-circuit
- 2c: energy supply of first functional block of first sub-circuit
- 2d: energy supply of second functional block of first sub-circuit
- 2e: energy supply of third functional block of first sub-circuit
- 2f: first functional block of first sub-circuit
- 2g: second functional block and test functionality of first sub-circuit
- 2h: third functional block of first sub-circuit, reprogrammable
- 3: second sub-circuit
- 3a: reprogrammable block, e.g. FPGA block, of second sub-circuit
- 3b: controller block of second sub-circuit
- 3c: memory block of second sub-circuit, e.g. embedded flash memory
- 3d: interface block of second sub-circuit
- 3e: access control block of second sub-circuit
- 3f: energy management block of second sub-circuit
- 4: terminals of SOC
- 5: pads on second sub-circuit
- 6: signal lines between first and second sub-circuits
- 6a,b,c: dedicated measurement lines
- 6d: signal lines between first and third sub-circuits
- 7: impedance matching device
- 8a: primary energy supply
- 8b: reserve energy supply
- 9: power supply lines to first sub-circuit
- 9a: power supply lines to third sub-circuit
- 10: third sub-circuit
- 10a: functional logic design of third sub-circuit
- 10b: interface of third sub-circuit
- 10c: energy supply of first functional block of third sub-circuit
- 10d: energy supply of second functional block of third sub-circuit
- 10e: first functional block of third sub-circuit
- 10f: second functional block and test functionality of third sub-circuit
- 11, 11': package substrates
- 12, 12': mold mass of package
- 13: electronic component
- 20-26: first circuit blocks of the first sub-circuit
- 30-44: second circuit blocks of the second sub-circuit

## Claims

1. System-on-chip, SOC, comprising:
a first sub-circuit having a defined interface and a defined fixed-hardware functionality;
a second reconfigurable sub-circuit being signal-connected via the interface to the first sub-circuit to exchange signals therewith; and
one or more terminals for electrically connecting the SOC to its periphery;
wherein:
the second sub-circuit is configured as an interface circuit between the one or more terminals and the first sub-circuit;
the first sub-circuit is split into a plurality of individual first circuit blocks;
the second sub-circuit is split into a plurality of individual second circuit blocks; and
at least one of said first circuit blocks is signal-connected via one or more signal connections, each running through one or more of the second circuit blocks, to one or more other first circuit blocks or one or more of the terminals; and
one or more of said signal connections are reconfigurable by means of the respective one or more second circuit blocks pertaining to the respective signal connection, such that the SOC is reconfigurable before or during its operation by way of reconfiguring at least one of said second circuit blocks.

2. The SOC of any one of the preceding claims, wherein the SOC is adapted to dynamically reconfigure itself during its operation by reconfiguring said at least one second circuit block based on a machine-learning based reconfiguration process.

3. The SOC of claim 2, wherein the SOC is adapted to apply the machine-learning based reconfiguration process for dynamically determining for a current or upcoming operational scenario of the SOC a respective optimized configuration among a set of multiple possible configurations of two or more of said second circuit blocks in dependence of the values of one or more input parameters defining that operational scenario.

4. The SOC of any one of the preceding claims, wherein a first subset of the second circuit blocks is implemented as a respective fixed-hardware circuit block and a disjoint second subset of the second circuit blocks is implemented as a respective reconfigurable circuit block.

5. The SOC of any one of the preceding claims, wherein the second sub-circuit is further configured as an integrated testing unit to test said fixed-hardware functionality of the first sub-circuit by applying one or more input signals to the first circuit and evaluating one or more output signals received via the interface from the first sub-circuit in response to the one or more input signals for conformance with one or more predetermined test criteria.

6. The SOC of claim 4 and 5, wherein:
two or more of the circuit blocks in the first subset of the second circuit blocks each implement a respective specific test instrument for testing a related aspect of said fixed-hardware functionality of the first sub-circuit; and
two or more circuit blocks in the second subset of the second circuit blocks are reconfigurable such as to selectively connect these test instruments to the first sub-circuit in order to selectively enable its testing by the respective one or more connected test instruments.

7. The SOC of claim 5 or 6, wherein the signal connection between the first and the second sub-circuits comprises one or more dedicated measurement lines that are configured exclusively for testing, measuring or monitoring the first sub-circuit or its functionality at respective predetermined measurement points within the first sub-circuit without controlling or otherwise influencing said functionality.

8. The SOC of any one of the preceding claims, wherein at least a subset of the first circuit blocks each implements a respective specific selectable predefined functional feature of a feature set of the first sub-circuit; and
one or more of the second circuit blocks are reconfigurable such as to selectively connect the first circuit blocks of said subset of the first circuit blocks to other second circuit blocks or one or more of the terminals in order to selectively enable the SOC to perform the respective one or more functional features of the respective connected ones of these first circuit blocks.

9. The SOC of any one of the preceding claims, wherein the SOC is configured such that any signal between the one or more terminals and the first sub-circuit passes through the second sub-circuit, which thus forms a sole interface circuit between the one or more terminals and the first sub-circuit.

10. The SOC of any one of the preceding claims, wherein the second sub-circuit is further configured to perform one or more of the following functions in relation to the first sub-circuit:
measure or monitor one or more signals or electrical properties of the first sub-circuit;
control or feed-back control the first sub-circuit;
substitute one or more functionalities of the first sub-circuit by performing them in the second sub-circuit instead of the first sub-circuit;
substitute one or more functionalities of a reprogrammable portion of the first sub-circuit by reprogramming that portion with program data being present in the second sub-circuit; or
extend one or more functionalities of the first sub-circuit by performing one or more extensions of functionalities of the first sub-circuit.

11. The SOC of claim 10, wherein the functionality of the first sub-circuit to be substituted is a functionality that was detected by an error detection functionality of the SOC as being defect.

12. The SOC of claim 10 or 11, wherein the second sub-circuit is further configured to substitute or extend a test functionality being implemented in the first sub-circuit itself, at least in parts.

13. The SOC of any one of the preceding claims, wherein at least one of the signal connections between the first and the second sub-circuits is an electrical connection that comprises one or more impedance matching devices being configured to optimize a proper transmission of RF-signals over said electrical connection.

14. The SOC of any one of the preceding claims, wherein the SOC is further configured to:
protect data to be communicated between the first and the second sub-circuits over the signal connection by means of data encryption; and/or
to monitor and control signals to be exchanged between with the SOC's periphery and the first sub-circuit based on predetermined access control rules.

15. The SOC of any one of the preceding claims, wherein:
the second-sub-circuit further comprises an energy-management functionality for managing the supply of energy to the first sub-circuit or parts thereof; and
the energy-management functionality is configured to perform one or more of the following energy control tasks in response to receiving a respective energy control signal:
selectively switch on or off the respective supply of energy to one or more selected circuit portions of the first sub-circuit;
selectively cause one or more selected circuit portions of the first sub-circuit to transition into a respective low-energy mode of operation;
selectively reroute at least parts of a supply of total available energy to one or more selected portions of the first sub-circuit, such that the energy is made available only or predominantly to those selected portions while the energy supply to non-selected portions is interrupted or reduced accordingly;
selectively connect a reserve energy supply, a device or circuit configured to reduce the supply of energy, or an energy regulating circuit to a respective energy supply path of one or more selected portions of the first sub-circuit to achieve an increase, a reduction or a regulation, respectively, of the supply of energy to the one or more selected portions of the first sub-circuit.

16. The SOC of claim 15, wherein the SOC itself is further configured to generate the energy control signal based on a measurement of a flow of electrical energy through one or more of the terminals or over one or more electrical connections between the second sub-circuit and the first sub-circuit.

17. The SOC of claim 15, wherein the energy-management functionality is further configured to:
receive the energy control signal in the form of an application-specific energy control signal from a host in the periphery of the SOC, when the host is executing a corresponding application program;
determine, based on said energy control signal, one or more of said energy control tasks and sub-circuits or circuit blocks thereof to be impacted by such one or more tasks; and
perform said determined one or more energy control tasks in relation to said determined one or more sub-circuits or circuit blocks thereof.
